# EUROPÄISCHE PATENTSCHRIFT

(11) **EP 1 343 722 B1**
(45) Veröffentlichungstag und Bekanntmachung des Hinweises auf die Patenterteilung: **25.08.2004**
(21) Anmeldenummer: 01995648.1
(22) Anmeldetag: 21.11.2001
(51) Int. Cl.: C01B 33/027, C01B 33/02, H01L 31/036

(54) **VERFAHREN ZUR HERSTELLUNG VON HOCHREINEM, GRANULAREM SILIZIUM**
METHOD FOR PRODUCING HIGHLY PURE, GRANULAR SILICON
PROCEDE D'OBTENTION DE SILICIUM GRANULAIRE DE HAUTE PURETE

(30) Priorität: 14.12.2000 DE 10062419
(43) Veröffentlichungstag der Anmeldung: 17.09.2003
(73) Patentinhaber: SOLARWORLD AKTIENGESELLSCHAFT, 53113 Bonn (DE)
(72) Erfinder: MLECZKO, Leslaw, 44801 Bochum (DE); BUCHHOLZ, Sigurd, 50825 Köln (DE); EZPELETA, Maria, Pilar Tejero, 09599 Freiberg (DE); SCHLÜTER, Oliver, Felix-Karl, 40627 Düsseldorf (DE)
(74) Vertreter: Rau, Albrecht
(86) Internationale Anmeldenummer: PCT/EP2001/013505
(87) Internationale Veröffentlichungsnummer: WO 2002/048033

(56) Entgegenhaltungen:
- WO-A-01/27029
- US-A- 4 444 811
- US-A- 4 784 840
- US-A- 5 139 762

## Beschreibung

Die vorliegende Erfindung betrifft ein Verfahren zur Herstellung von hochreinem, granularem Silizium durch Zersetzung eines siliziumhaltigen Gases und die Verwendung des so hergestellten elementaren Siliziums in der Photovoltaik und der Halbleitertechnologie.

Unter siliziumhaltigen Gasen werden Siliziumverbindungen oder Gemische von Siliziumverbindungen verstanden, die sich unter den erfindungsgemäßen Bedingungen aus der Gasphase unter Abscheidung von Silizium zersetzen lassen. Siliziumfreie Gase im Sinne dieser Erfindung sind solche Gase, die keine Siliziumverbindungen enthalten.

Zur Gewinnung von elementarem Silizium eines Reinheitsgrades, das dessen Verwendung in der Photovoltaik beziehungsweise in der Halbleitertechnologie erlaubt, sind Verfahren zur thermischen Zersetzung von flüchtigen Siliziumverbindungen bekannt. Solche thermischen Zersetzungen können beispielsweise in Wirbelschichtreaktoren durchgeführt werden, in denen kleine Siliziumpartikel vorgelegt und diese durch Einströmen eines geeigneten siliziumhaltigen Gases oder Gasgemisches fluidisiert werden, wobei das Gasgemisch neben siliziumhaltigen auch siliziumfreie Gase enthalten kann. Die thermische Zersetzung der flüchtigen Siliziumverbindung soll im Idealfall ausschließlich auf der Oberfläche der vorgelegten Siliziumpartikel stattfinden. Die vorgelegten kleinen Siliziumpartikeln, im folgenden Keimpartikeln genannt, bilden innerhalb des Reaktors eine große Fläche zur Abscheidung des Siliziums. Partikeln, die auf eine genügende Größe angewachsen sind, werden aus dem Reaktor entfernt und es werden neue Keimpartikeln zugegeben.

Es ist aus US-A-3,012,861 bekannt, dass sich die Zersetzung von Silan bei einem Unterdruck im Reaktor und hohen Partialdrücken an silanhaltigem Gas durchführen lässt.

Es wurde nun überraschend gefunden, dass sich bei einer Führung der Reaktion unter Unterdruck, neben Staub (Partikeldurchmesser Dp = <1 µm bis ca. 25 µm) und den Siliziumgranalien (Dp = >1 00 bis <5000 µm) auch eine Fraktion kleiner Partikel (Dp = 25 bis < 100 µm) bildet, die innerhalb der Wirbelschicht verbleibt. Auf dieser Partikelfraktion scheidet sich ebenfalls Silizium während der Reaktion ab, d.h. diese Partikel wirken als Keimpartikel. Diese Partikel machen also die Zugabe von Keimpartikeln mit einem kleinen Durchmesser überflüssig. Dies minimiert das Risiko der Verunreinigung des Reinstsiliziums durch und während der Keimpartikelnzugabe und macht das Verfahren einfacher, da auf aufwendige Dosier-Systeme verzichtet werden kann. Weiter kann das Verfahren leicht in einem kontinuierlichen Verfahren angewandt werden.

Es zeigte sich jedoch auch, dass bei der kontinuierlichen Erzeugung von Keimpartikeln während der Reaktionsführung im Reaktor eine Akkumulation von feinen Keimpartikeln dann auftritt, wenn die Bildungsrate der kleinen Partikeln größer ist, als die Austragsrate an Partikeln der gewünschten Größe, d.h. wenn neue Partikeln schneller gebildet werden als Partikeln durch die Silanzersetzung aufwachsen und eine definierte Größe erreichen. Da die kleinen Keimpartikeln aufgrund ihres geringeren Durchmessers eine (auf das Gewicht bezogene) höhere spezifische Oberfläche aufweisen als die aufgewachsenen Granalien, führt dies dazu, dass sich eine sehr breite Partikelgrößenverteilung einstellt und der Anteil an Keimpartikeln ständig zunimmt.

Aus der US 4,314,525 A ist ein Verfahren zur Herstellung von hochreinem Silizium bekannt. Dort werden Siliziumkernpartikel in einem ersten Wirbelschichtreaktor durch thermische Zersetzung eines siliziumhaltigen Gases hergestellt. Diese Kempartikel werden dann in einen zweiten Wirbelschichtreaktor eingeführt, wo sie fluidisiert werden. Ein siliziumhaltiges Gas wird in den Reaktor eingeleitet und thermisch zersetzt, wodurch eine Abscheidung von Silizium auf die Kempartikel stattfindet.

Aus der US 4,784,840 A ist die Verwendung von Silizium zur Herstellung von Halbleitern bekannt.

Die Aufgabe der vorliegenden Erfindung bestand nun darin, eine Verfahrensführung zu entwickeln, die eine kontrollierte Erzeugung von Keimpartikeln im Reaktionsraum erlaubt, ohne dass es zur oben beschriebenen Akkumulation kommt.

Die Bildungsgeschwindigkeit der oben beschriebenen Keimpartikeln während der Zersetzung eines siliziumhaltigen Gases in einem Wirbelschichtreaktor hängt stark von den gewählten Reaktionsbedingungen, insbesondere Silanpartialdruck, Gesamtdruck, Fluidisierungshilfsgas, Gasgeschwindigkeit und Reaktionstemperatur ab. Es wurde nun überraschend gefunden, dass eine Verfahrensführung mit mindestens zwei Betriebszuständen, in denen in einem Zustand verstärkt Keimpartikeln generiert werden und in einem weiteren Zustand diese Partikeln durch hauptsächlich stattfindende Abscheidung von Silizium auf den Keimpartikeln vergrößert werden, die vorliegende Aufgabe löst.

Gegenstand der Erfindung ist somit ein Verfahren zur Herstellung von granularem Silizium durch thermische Zersetzung eines siliziumhaltigen Gases, das dadurch gekennzeichnet ist, dass eine Verfahrensführung mit mindestens zwei Betriebszuständen durchgeführt wird, in denen
a) in einem Zustand verstärkt Keimpartikeln aus der thermischen Zersetzung des siliziumhaltigen Gases generiert werden und
b) in einem weiteren Zustand diese Partikeln durch hauptsächlich stattfindende Abscheidung von Silizium vergrößert werden.

Die Herstellung von granularem Silizium wird so durchgeführt, dass
a) in einem Betriebszustand der Partialdruck des siliziumhaltigen Gases > 200 mbar beträgt und
b) in einem weiteren Betriebszustand der Partialdruck des siliziumhaltigen Gases < 200 mbar beträgt.

Der Partialdruck des siliziumhaltigen Gases kann dabei sowohl durch die Einstellung des Gesamtdrucks, als auch durch die Einstellung der Konzentration an siliziumhaltigem Gas im Gasstrom, der dem Reaktor zugeführt wird, beeinflusst werden.

Die Betriebszustände können unmittelbar aufeinander folgend zyklisch durchlaufen werden. Es ist jedoch auch möglich, dass die Betriebszustände a) und b) durch einen oder mehrere weitere Betriebszustände unterbrochen werden.

Bei den weiteren Betriebszuständen handelt es sich beispielsweise um Spülungen mit Inertgasen oder Reaktivgasen, eine Erhöhung oder Erniedrigung der Temperatur, eine Veränderung der Konzentration des siliziumhaltigen Gases, eine Veränderung der Gasgeschwindigkeit, eine Zugabe von weiteren siliziumhaltigen Gasen oder die Zugabe oder Entnahme von Partikeln.

Das erfindungsgemäße Verfahren kann in verschiedenen Reaktortypen durchgeführt werden. Geeignete Reaktoren, insbesondere Wirbelbettreaktoren sind bereits bekannt. Bevorzugt ist die Verwendung eines Wirbelbettreaktors. Beispielhaft seien hier Reaktoren mit einem blasenbildenden oder zirkulierenden Wirbelbett genannt, des weiteren Sprudelbett-, Wanderbett- und Fallrohrreaktoren.

Das Verfahren lässt sich beispielsweise kontinuierlich oder diskontinuierlich durchführen. Bevorzugt ist die kontinuierliche Vorgehensweise. Der Austrag der durch Abscheidung gebildeten Siliziumpartikel aus dem Reaktor kann kontinuierlich oder diskontinuierlich erfolgen. Durch die erfindungsgemäße Verfahrensführung wird der Verlust von Partikeln durch Austrag von Produkt aus dem Reaktor durch die in-situ-Generierung neuer Keimpartikel ersetzt. Es ist aber auch möglich zusätzlich Keimpartikel zuzugeben. Die zusätzliche Zugabe von Keimpartikeln kann kontinuierlich oder absatzweise durchgeführt werden.

Als siliziumhaltiges Gas kommen Silane, Siliziumiodide und Halosilane des Chlors, Broms und Iods in Frage. Es können auch Gemische der genannten Verbindungen verwendet werden. Dabei ist es unerheblich, ob die Siliziumverbindung bei Raumtemperatur bereits gasförmig ist oder zunächst in den Gaszustand überführt werden muss. Die Überführung in den Gaszustand kann beispielsweise thermisch erfolgen.

Bevorzugt werden Silane eingesetzt. Beispielhaft seien SiH₄, Si₂H₆, Si₃H₈, Si₄H₁₀ und Si₆H₁₄ genannt. Besonders bevorzugt ist SiH₄.

Es ist möglich, das erfindungsgemäße Verfahren zur Herstellung hochreinen, granularen Siliziums unter Zugabe eines siliziumfreien Gases oder einer Mischung mehrerer siliziumfreier Gase durchzuführen. Beispielsweise kann die zugesetzte Menge an siliziumfreiem Gas 0 bis 98 Vol.-% bezogen auf das insgesamt zugeführte Gas, betragen. Der Zusatz des siliziumfreien Gases und/oder der Mischung aus siliziumfreien Gasen beeinflusst die Bildung von Siliziumstaub bei der thermischen Zersetzung des siliziumhaltigen Gases. Es ist jedoch auch möglich, auf den Zusatz eines siliziumfreien Gases zu verzichten.

Geeignete siliziumfreie Gase sind beispielsweise die Edelgase, Stickstoff und Wasserstoff, wobei die siliziumfreien Gase einzeln oder in beliebiger Kombination eingesetzt werden können. Bevorzugt sind Stickstoff und Wasserstoff, besonders bevorzugt ist Wasserstoff.

Die Temperatur kann im Temperaturbereich von 300°C bis 1400°C variiert werden. Sie muss jedoch so hoch sein, dass die Zersetzung des siliziumhaltigen Gases gewährleistet ist und darf die Schmelztemperatur des hergestellten Siliziums nicht überschreiten. Bei Verwendung von SiH₄ liegt der vorteilhafte Temperaturbereich zwischen 500°C und 1400°C. Bevorzugt ist eine Zersetzungstemperatur von 600°C bis 1000°C, besonders bevorzugt 620°C bis 800°C. Bei Verwendung von SiI₄ liegt der entsprechende Bereich zwischen 850°C und 1250°C, bei anderen Halosilanen zwischen 500°C und 1400°C.

In einer besonderen Ausführungsform des erfindungsgemäßen Verfahrens wird als siliziumhaltiges Gas SiH₄ verwendet und bei Temperaturen von 500°C bis 1400°C gearbeitet.

In einer bevorzugten Ausführungsform des erfindungsgemäßen Verfahrens werden in einem Wirbelschichtreaktor im Reaktionsraum Feststoffpartikel, im weiteren Partikel genannt, vorgelegt. Die Partikel bilden ein Festbett, durch das das zugeführte Gas eingeströmt wird. Die Einströmgeschwindigkeit des zugeführten Gases wird so eingestellt, dass das Festbett fluidisiert wird und sich eine Wirbelschicht ausbildet. Die entsprechende Vorgehensweise ist dem Fachmann an und für sich bekannt. Die Einströmgeschwindigkeit des zugeführten Gases muss mindestens der Lockerungsgeschwindigkeit entsprechen. Unter Lockerungsgeschwindigkeit wird dabei die Geschwindigkeit verstanden, mit der ein Gas durch ein Bett aus Partikeln strömt und unterhalb derer das Festbett erhalten bleibt, d.h. unterhalb derer die Bettpartikel weitgehend unbewegt bleiben. Oberhalb dieser Geschwindigkeit beginnt die Fluidisierung des Betts, d.h. die Bettpartikel bewegen sich und es bilden sich erste Blasen.

Die Einströmgeschwindigkeit des zugeführten Gases beträgt bei dieser bevorzugten Ausführungsform die ein- bis zehnfache, bevorzugt die eineinhalb- bis siebenfache Lockerungsgeschwindigkeit.

Vorteilhaft werden Partikel eingesetzt, die einen Durchmesser von 50 bis 5000 µm aufweisen.

Bei den verwendeten Partikeln handelt es sich vorzugsweise um Siliziumpartikel. Vorteilhafterweise haben diese Siliziumpartikel die Reinheit, die auch für das hergestellte hochreine, granulare Silizium gewünscht wird. Es ist aber auch möglich Siliziumpartikel mit bestimmten Dotierungen einzusetzen, wenn dotiertes Material gewünscht wird.

Das erfindungsgemäße Verfahrens kann beispielsweise so durchgeführt werden, dass die Konzentration an siliziumhaltigem Gas konstant gehalten wird und die erfindungsgemäß zu durchlaufenden Betriebszustände durch Änderung des Gesamtdrucks eingestellt werden. Vorzugsweise beträgt die Konzentration an siliziumhaltigem Gas 10 bis 100 Vol.-%, besonders bevorzugt 50 bis 100 Vol.-% bezogen auf das gesamte dem Reaktor zugeführte Gas.

Es ist auch möglich, das erfmdungsgemäße Verfahrens so durchzuführen, dass der Gesamtdruck konstant gehalten wird und die erfindungsgemäß zu durchlaufenden Betriebszustände durch Änderung der Konzentration an siliziumhaltigem Gas eingestellt werden. Vorzugsweise beträgt der Gesamtdruck 100 bis 2000 mbar, besonders bevorzugt 400 bis 1200 mbar. Alle angegebenen Druckwerte sind absolute Druckwerte. Wird das Verfahren in einer Wirbelschicht durchgeführt ist unter den angegebenen Druckwerten der, in Strömungsrichtung gesehen, hinter der Wirbelschicht herrschende Druck zu verstehen, wenn dies nicht anders angegeben wird.

Selbstverständlich können die erfindungsgemäß zu durchlaufenden Betriebszustände auch durch Änderung des Gesamtdrucks und der Konzentration an siliziumhaltigem Gas eingestellt werden.

Vorzugsweise wird bei konstanter Konzentration an siliziumhaltigem Gas und Variation des Gesamtdrucks gearbeitet.

Es ist zu beachten, dass insbesondere in Abhängigkeit vom gewählten siliziumhaltigen Gas und der Temperatur ein Bereich des Gesamtdrucks und der Konzentration an siliziumhaltigem Gas existiert, an dem die Menge an gebildeten Keimpartikeln maximal wird. Diese Bereiche lassen sich experimentell ermitteln.

Wird als siliziumhaltiges Gas beispielsweise Silan SiH₄ in einer Konzentration von 90 bis 100 Vol.-% bei einer Temperatur von 650 bis 700°C umgesetzt, wird bei konstanter Silankonzentration die maximale Menge an Keimpartikeln bei einem Gesamtdruck von etwa 600 bis 700 mbar erreicht und nimmt bei weiterer Druckerhöhung wieder ab. Vorzugsweise wird der Betriebszustand in dem verstärkt Keimpartikeln aus der thermischen Zersetzung des siliziumhaltigen Gases generiert werden in diesem Fall demnach im entsprechenden Druckbereich durchgeführt.

Da die Keimpartikelnbildungsgeschwindigkeit durch die Wahl der Reaktionsbedingungen gesteuert werden kann, werden in der erfindungsgemäßen Verfahrensführung unterschiedliche Betriebsmodi kombiniert, um einerseits Keimpartikeln "in-situ" zu generieren und andererseits eine Akkumulation der Keimpartikeln zu vermeiden.

Die Zugabe von Wasserstoff zum siliziumhaltigen Gas, das dem Reaktor zugeführt wird, in dem die thermische Zersetzung erfolgt, führt zu einer Erhöhung der Menge an gebildeten Keimpartikeln, solange gewährleistet ist, dass der Partialdruck des siliziumhaltigen Gases größer als 200 mbar ist. Es ist also vorteilhaft, das erfindungsgemäße Verfahren so zu führen, dass in dem Betriebszustand, in dem es vermehrt zur Bildung von Keimpartikeln kommt, dem siliziumhaltigen Gas Wasserstoff zugegeben wird.

Neben den bereits erläuterten verfahrenstechnischen Vorteilen zeichnet sich das erfindungsgemäße Verfahren auch dadurch aus, dass die gewonnenen Siliziumpartikeln, die durch Aufwachsen von Silizium auf in-situ gebildete Keimpartikel entstehen, eine sphärische, kernlose Struktur aufweisen. Unter kernloser Struktur wird dabei verstanden, dass die Siliziumpartikeln über das gesamte Kornvolumen eine homogene Struktur aufweisen. Erfolgt die thermische Zersetzung eines siliziumhaltigen Gases hingegen in bekannter Weise auf Keimpartikeln, die nicht in-situ generiert wurden, so entsteht kein Siliziumpartikel mit homogener Struktur, sondern ein Siliziumpartikel, bei dem das abgeschiedene Silizium eine Schicht um einen Kern, nämlich das eingesetzte Keimpartikel bildet. Wird die Schnittfläche durch ein solches Siliziumpartikel mittels Rasterelektronenmikroskopie untersucht, lässt sich der Übergang von Keimpartikel zu aufgewachsenem Silizium klar erkennen. Ein Siliziumpartikel, das nach dem erfindungsgemäßen Verfahren erzeugt wurde, weist hingegen keinen solchen Übergang auf.

Die nach dem erfindungsgemäßen Verfahren herstellbaren kernlosen Siliziumpartikel weisen vorteilhafte Brucheigenschaften, Fließeigenschaften und Schmelzeigenschaften auf. Insbesondere die Schmelzeigenschaften sind bei einer Weiterverarbeitung der Siliziumpartikel, beispielsweise zur Herstellung von multikristallinen Siliziumblöcken oder Siliziumscheiben, besonders wichtig.

Ein weiterer Gegenstand der Erfindung sind daher hochreine, granulare Siliziumpartikel, die sich dadurch auszeichnen, dass sie eine kernlose Struktur aufweisen.

Vorzugsweise werden die hochreinen, granularen Siliziumpartikel mit kernloser Struktur nach dem erfindungsgemäßen Verfahren hergestellt.

Das nach dem erfindungsgemäßen Verfahren hergestellte Silizium kann beispielsweise in der Photovoltaik und zur Herstellung von elektronischen Bauteilen verwendet werden.

Die folgenden Beispiele illustrieren mögliche Betriebszustände der erfindungsgemäßen Verfahrensführung, wobei die Beispiele jedoch nicht einschränkend aufzufassen sind. Prozentangaben in den Beispielen stellen, soweit nichts anderes gesagt ist, Gewichtsprozent dar.

### Beispiel 1 Steuerung der Keimpartikelbildung durch den Silanpartialdruck

In einem Versuchswirbelschichtreaktor (Durchmesser = 52,4 mm, Höhe mit expandiertem Kopf = 1600 mm) wurden 800 g Siliziumpartikeln mit einem mittleren Durchmesser von 338 µm vorgelegt. Der Versuch wurde bei einem Druck von 500 mbar durchgeführt. Nach dem Anfahren und Aufheizen des Wirbelbettes auf eine Temperatur von 680°C in Stickstoff wurde die Silankonzentration (SiH₄) am Eingang des Reaktors von 0 auf 100 Vol.-% bezogen auf die Gesamtmenge an zugeführtem Silan und Stickstoff eingestellt. Der Versuch, im weiteren als V1 bezeichnet, wurde solange betrieben, bis die Partikeln durch die Abscheidung von Silan (SiH₄) im mittleren Durchmesser von 338 auf 360 µm angewachsen waren. Nach Abkühlen dieser Partikel wurden diese aus dem Reaktor entfernt. Dann wurden anhand einer Massenbilanz die Selektivitäten zur Bildung von CVD-Silizium, Keimpartikeln und Staub bestimmt. Es wurden insgesamt 466,9 g Silizium abgeschieden. Dabei wurden die in Tabelle 1 aufgelisteten Selektivitäten erhalten, die Selektivität zur Bildung von Keimpartikeln lag bei 4,6 %.

In einem weiteren Versuch (V2) wurden 800 g Siliziumpartikeln mit einem mittleren Durchmesser von 346 µm vorgelegt, der Gesamtdruck im Reaktor auf 650 mbar erhöht und der Versuch, wie oben beschrieben, durchgeführt. Es wurden 635,2 g Silizium abgeschieden, was zu einem Anwachsen des mittleren Partikeldurchmessers von 346 auf 384 µm führte. Die Selektivität zur Bildung von Keimpartikeln stieg dabei auf 24,4 % an.

Eine weitere Erhöhung des Silanpartialdrucks auf 700 mbar im Versuch V3 führte zu einem erneuten Absinken der Selektivität zu Keimpartikeln auf 16,8 %.

Das Beispiel illustriert deutlich den Einfluss des Gesamtdrucks bei gleichbleibendem Anteil an siliziumhaltigem Gas im insgesamt zugeführten Gas auf die Produktverteilung.

**Tabelle 1 :**

| | Pₜₒₜ,mbar | x_{SiH4}, VOl-% | S_{CVD}, % | S_{Keimpart}, % | S_{Staub}, % |
|---|---|---|---|---|---|
| V1 | 500 | 100 | 75,9 | 4,6 | 19,5 |
| V2 | 650 | 100 | 62,5 | 24,4 | 13,1 |
| V3 | 700 | 100 | 71,1 | 16,8 | 12,1 |
| **p**_{**tot**}**: Gesamtdruck** X_{SiH4}: Anteil an SiH₄ im zugeführten Gasstrom S_{CVD}: Selektivität zur Bildung von CVD-Silizium S_{Keimpart}.: Selektivität zur Bildung von Keimpartikeln S_{Staub}: Selektivität zur Bildung von Staub | | | | | |

### Beispiel 2 Steuerung der Keimpartikelbildung durch den Wasserstoffpartialdruck

In einem Versuchswirbelschichtreaktor (Durchmesser = 52,4 mm, Höhe mit expandiertem Kopf = 1600 mm) wurden 800 g Siliziumpartikeln mit einem mittleren Durchmesser von 334-345 µm vorgelegt. Das Experiment wurde bei einem Druck von 500 mbar (V1, V4, V5) bzw. 650 mbar (V6) durchgeführt. Nach dem Anfahren und Aufheizen des Wirbelbettes auf eine Temperatur von 680°C in Stickstoff wurde die Silankonzentration (SiH₄) am Eingang des Reaktors von 0 auf 100 Vol.-% bezogen auf die Gesamtmenge an zugeführtem Silan und Stickstoff eingestellt. Dann wurde jeweils eine Konzentration an Wasserstoff eingestellt, so dass sich die in Tabelle 2 angegebenen Partialdrücke für Wasserstoff ergaben, und die Reaktion durchgeführt, bis die Partikeln durch die Abscheidung von Silan (SiH₄) im mittleren Durchmesser von 334-345 µm auf 356-383 µm angewachsen waren. Die angewachsenen Partikeln wurden nach dem Abkühlen aus dem Reaktor entfernt. Dann wurden anhand einer Massenbilanz die Selektivitäten zur Bildung von CVD-Silizium, Keimpartikeln und Staub bestimmt (Tabelle 2). Es zeigte sich, dass mit zunehmendem Wasserstoffpartialdruck die Selektivität zur Bildung von Keimpartikeln von 4,6 % auf 20,8 % zunimmt. Durch eine Zudosierung von Wasserstoff lässt sich also die Menge an gebildeten Keimpartikeln erhöhen.

Bei geringen Silanpartialdrücken, d.h. bei Silanpartialdrücken kleiner 200 mbar, geht die Selektivität zu Keimpartikeln jedoch trotz hoher Wasserstoffpartialdrücke wieder stark zurück.

**Tabelle 2 :**

| | Pₜₒₜ, mbar | P_{SiH₄}, mbar | P_{H₂}, mbar | S_{CVD}, % | S_{Keimpart}, % | S_{Staub}, % |
|---|---|---|---|---|---|---|
| V1 | 500 | 500 | 0 | 75,9 | 4,6 | 19,5 |
| V4 | 500 | 450 | 50 | 72,3 | 8,2 | 19,5 |
| V5 | 500 | 400 | 100 | 69,8 | 13,4 | 16,8 |
| V6 | 650 | 450 | 200 | 66,9 | 20,8 | 12,3 |
| **p**_{**tot**}**: Gesamtdruck** p_{SiH4}: Partialdruck von SiH₄ im zugeführten Gasstrom p_{H2}: Partialdruck von H₂ im zugeführten Gasstrom S_{CVD}: Selektivität zur Bildung von CVD-Silizium S_{Keimpart}.: Selektivität zur Bildung von Keimpartikeln S_{Staub}: Selektivität zur Bildung von Staub | | | | | | |

### Beispiel 3 Betriebszustand zur verstärkten Bildung von Keimpartikeln

In einem Versuchswirbelschichtreaktor (Durchmesser = 52,4 mm, Höhe mit expandiertem Kopf = 1600 mm) wurden 810 g Siliziumpartikeln mit einem mittleren Durchmesser von 284 µm vorgelegt. Das Experiment wurde bei einem Druck von 500 mbar durchgeführt. Nach dem Anfahren und Aufheizen des Wirbelbettes auf eine Temperatur von 680°C in Stickstoff wurde die Silankonzentration (SiH₄) im Versuch V7 am Eingang des Reaktors von 0 auf 100 Vol.-% bezogen auf die Gesamtmenge an zugeführtem Silan und Stickstoff eingestellt. Nachdem die Partikeln durch die Abscheidung von Silan (SiH₄) im mittleren Durchmesser von 284 µm auf 333 µm angewachsen waren, wurden diese nach dem Abkühlen aus dem Reaktor entfernt. Dann wurden anhand einer Massenbilanz die Selektivitäten zur Bildung von CVD-Silizium, Keimpartikeln und Staub bestimmt (Tabelle 3).

Anschließend wurde eine repräsentative Probe von 800 g der Siliziumpartikel, die in V7 gebildet wurden, einem erneuten Pyrolyseprozess bei gleichen Bedingungen unterworfen (V8). Der mittlere Durchmesser der Partikel wuchs dabei von 333 µm auf 361 µm. Die Selektivität zu Keimpartikeln erhöhte sich von 22,8 % in V7 auf 44,8 % (Tabelle 3).

Die gewählten Reaktionsbedingungen führen demnach zu einer Akkumulation von Keimpartikeln in der Wirbelschicht, wobei die Keimpartikel von durchschnittlich 45 µm nach V7 auf 72 µm nach V8 wuchsen. Bei steigender Betriebsdauer erhöht sich also sowohl die Anzahl als auch die Größe der Keimpartikel.

**Tabelle 3 :**

| | Pₜₒₜ, mbar | P_{SiH4}, mbar | S_{CVD}, % | S_{Keimpart}, % | S_{Staub}, % |
|---|---|---|---|---|---|
| V7 | 500 | 500 | 64,3 | 22,8 | 12,9 |
| V8 | 500 | 500 | 38,9 | 44,8 | 16,3 |
| **p**_{**tot**}**: Gesamtdruck** p_{SiH4}: Partialdruck von SiH₄ im zugeführten Gasstrom S_{CVD}: Selektivität zur Bildung von CVD-Silizium S_{Keimpart}: Selektivität zur Bildung von Keimpartikeln S_{Staub}: Selektivität zur Bildung von Staub | | | | | |

### Beispiel 4 Betriebszustand zum verstärkten Anwachsen der Keimpartikeln

In einem Versuchswirbelschichtreaktor (Durchmesser = 52,4 mm, Höhe mit expandiertem Kopf = 1600 mm) wurden 890 g Siliziumpartikeln mit einem mittleren Durchmesser von 345 µm vorgelegt. Der Versuch (V9) wurde bei einem Druck von 500 mbar durchgeführt. Nach dem Anfahren und Aufheizen des Wirbelbettes auf eine Temperatur von 680°C in Wasserstoff wurde die Silankonzentration (SiH₄) am Eingang des Reaktors von 0 auf 10 Vol.-% bezogen auf die Gesamtmenge an zugeführtem Silan und Stickstoff eingestellt und die Reaktion durchgeführt, bis die Siliziumpartikeln durch die Abscheidung von Silan (SiH₄) im mittleren Durchmesser von 345 µm auf 366 µm angewachsen waren. Diese wurden nach dem Abkühlen aus dem Reaktor entfernt. Dann wurden anhand einer Massenbilanz die Selektivitäten zur Bildung von CVD-Silizium, Keimpartikeln und Staub bestimmt (Tabelle 4). Es zeigte sich keine Bildung von Keimpartikeln.

**Tabelle 4 :**

| | Pₜₒₜ, mbar | X_{SiH4}, Vol.-% | S_{CVD}, % | S_{Keimpart.,} % | S_{Staub,} % |
|---|---|---|---|---|---|
| V9 | 500 | 10 | 88,6 | 0,0 | 11,4 |
| **p**_{**tot**}**: Gesamtdruck** x_{SiH4}: Anteil an SiH₄ im zugeführten Gasstrom S_{CVD}: Selektivität zur Bildung von CVD-Silizium S_{Keimpart}: Selektivität zur Bildung von Keimpartikeln S_{Staub}: Selektivität zur Bildung von Staub | | | | | |

## Patentansprüche

1. Herstellung von granularem Silizium durch thermische Zersetzung eines siliziumhaltigen Gases, **dadurch gekennzeichnet, dass** eine Verfahrensführung mit mindestens zwei Betriebszuständen durchgeführt wird, in denen
a) in einem Zustand verstärkt Keimpartikeln aus der thermischen Zersetzung des siliziumhaltigen Gases generiert werden und
b) in einem weiteren Zustand diese Partikeln durch hauptsächlich stattfindende Abscheidung von Silizium vergrößert werden,
wobei eine Verfahrensführung mit mindestens zwei Betriebszuständen durchgeführt wird, wobei
c) in einem Betriebszustand der Partialdruck des siliziumhaltigen Gases > 200 mbar beträgt und
d) in einem weiteren Betriebszustand der Partialdruck des siliziumhaltigen Gases < 200 mbar beträgt.

2. Verfahren nach wenigstens einem der Anspruch 1, **dadurch gekennzeichnet, dass** die Betriebszustände a) und b) einerseits oder c) und d) andererseits durch einen oder mehrere weitere Betriebszustände unterbrochen werden.

3. Verfahren nach Anspruch 2, **dadurch gekennzeichnet, dass** es sich bei den weiteren Betriebszuständen um Spülungen mit Inertgasen oder Reaktivgasen, eine Erhöhung oder Erniedrigung der Temperatur, eine Veränderung der Konzentration des siliziumhaltigen Gases, eine Veränderung der Gasgeschwindigkeit, eine Zugabe von weiteren siliziumhaltigen Gasen oder die Zugabe oder Entnahme von Partikeln handelt.

4. Verfahren nach wenigstens einem der Ansprüche 1 bis 3, **dadurch gekennzeichnet, dass** die thermische Zersetzung eines siliziumhaltigen Gases in Gegenwart von Partikeln durchgeführt wird, die vom zugeführten Gas derart durchströmt werden, dass die Partikeln fluidisiert werden und sich eine Wirbelschicht ausbildet.

5. Verfahren nach Anspruch 4, **dadurch gekennzeichnet, dass** als Partikel Siliziumpartikel verwendet werden.

6. Verfahren nach wenigstens einem der Ansprüche 4 bis 5, **dadurch gekennzeichnet, dass** die Partikel einen Durchmesser zwischen 50 und 5000 µm aufweisen.

7. Verfahren nach wenigstens einem der Ansprüche 4 bis 6, **dadurch gekennzeichnet, dass** die Gasstromgeschwindigkeit des zugeführten Gases im Verhältnis zur Lockerungsgeschwindigkeit Werte von 1 bis 10 annimmt.

8. Verfahren nach wenigstens einem der Ansprüche 1 bis 7, **dadurch gekennzeichnet, dass** eine zusätzliche Zugabe von Partikeln und der Austrag des hergestellten Siliziums kontinuierlich oder absatzweise durchgeführt wird.

9. Verfahren nach wenigstens einem der Ansprüche 1 bis 8, **dadurch gekennzeichnet, dass** als siliziumhaltiges Gas ein Silan verwendet wird.

10. Verfahren nach wenigstens einem der Ansprüche 1 bis 9, **dadurch gekennzeichnet, dass** als siliziumhaltiges Gas SiH₄ verwendet und bei Temperaturen von 500 bis 1400°C gearbeitet wird.

11. Verfahren zur Herstellung photovoltaischer Bauteile mit folgenden Verfahrensschritten:
a) Herstellen von granularem Silizium durch thermische Zersetzung eines siliziumhaltigen Gases, wobei eine Verfahrensführung mit mindestens zwei Betriebszuständen durchgeführt wird, in denen
- in einem Zustand verstärkt Keimpartikeln aus der thermischen Zersetzung des siliziumhaltigen Gases generiert werden und
- in einem weiteren Zustand diese Partikeln durch hauptsächlich stattfindende Abscheidung von Silizium vergrößert werden,
wobei eine Verfahrensführung mit mindestens zwei Betriebszuständen durchgeführt wird, wobei
- in einem Betriebszustand der Partialdruck des siliziumhaltigen Gases > 200 mbar beträgt und
- in einem weiteren Betriebszustand der Partialdruck des siliziumhaltigen Gases < 200 mbar beträgt,
b) Fertigen photovoltaischer Bauteile, aus dem hergestellten granularen Silizium.

12. Verfahren zur Herstellung elektronischer Bauteile mit folgenden Verfahrensschritten:
a) Herstellung von granularem Silizium durch thermische Zersetzung eines siliziumhaltigen Gases, wobei eine Verfahrensführung mit mindestens zwei Betriebszuständen durchgeführt wird, in denen
- in einem Zustand verstärkt Keimpartikeln aus der thermischen Zersetzung des siliziumhaltigen Gases generiert werden und
- in einem weiteren Zustand diese Partikeln durch hauptsächlich stattfindende Abscheidung von Silizium vergrößert werden,
wobei eine Verfahrensführung mit mindestens zwei Betriebszuständen durchgeführt wird, und wobei
- in einem Betriebszustand der Partialdruck des siliziumhaltigen Gases > 200 mbar beträgt und
- in einem weiteren Betriebszustand der Partialdruck des siliziumhaltigen Gases < 200 mbar beträgt,
b) Fertigen elektronischer Bauteile, aus dem hergestellten granularen Silizium.

## Claims

1. The manufacture of granular silicon by thermal decomposition of a gas containing silicon, **characterized in that** the reaction method comprises at least two operating states, wherein
a) one state comprises the increased formation of nucleus particles from the thermal decomposition of said gas containing silicon, and
b) another state comprises the mainly occurring separation of the silicon with expansion of the diameter of such particles;
with the reaction method comprising at least two operating states, wherein
c) in one operating state the partial pressure of the gas containing silicon is > 200 mbar, and
d) in another operating state the partial pressure of the gas containing silicon is < 200 mbar.

2. A method according to Claim 1, **characterized in that** said operating states a) and b) on the one hand or c) and d) on theother are interrupted by one or several other operating states.

3. A method according to Claim 2, **characterized in that** said other operating states are rinsing with inert gases or reactive gases, increase or reduction of temperature, modification of the concentration of silicic gas, modification of gas velocity, addition of further silicic gases or addition or removal of particles.

4. A method according to at least one of Claims 1 to 3, **characterized in that** the thermal decomposition of a silicic gas is carried out in the presence of particles through which the introduced gas streams in a way such that the particles are fluidized and a fluidized bed develops.

5. A method according to Claim 4, **characterized in that** the particles used are silicon particles.

6. A method according to at least one of Claims 4 to 5, **characterized in that** the particles have a diameter between 50 and 5000 µm.

7. A method according to at least one of Claims 4 to 6, **characterized in that** the streaming velocity of the introduced gas adopts values from 1 to 10 in relation to the loosening velocity.

8. A method according to at least one of Claims 1 to 7, **characterized in that** an additional addition of nucleus particles and the discharge of the silicon produced are carried out continuously or intermittently.

9. A method according to at least one of Claims 1 to 8, **characterized in that** the silicic gas used is a silane.

10. A method according to at least one of Claims 1 to 9, **characterized in that** the silicic gas used is SiH₄ and that the reaction is carried out at temperatures from 500 to 1400°C.

11. A method for the manufacture of photovoltaic components, comprising the following steps:
a) manufacturing granular silicon by thermal decomposition of silicon containing gas, with a reaction method comprising at least two operating states, wherein
- one state comprises the increased formation of nucleus particles from the thermal decomposition of the silicon containing gas, and
- another state comprises the mainly occurring separation of the silicon with expansion of the diameter of such particles;
with a reaction method comprising at least two operating states, wherein
- in one operating state the partial pressure of the silicon containing gas is > 200 mbar, and
- in another operating state the partial pressure of the silicon containing gas is < 200 mbar;
b) manufacturing photovoltaic components from the granular silicon produced.

12. A method for the manufacture of electronic components, comprising the following steps:
a) manufacturing granular silicon by thermal decomposition of silicon containing gas, with a reaction method comprising at least two operating states, wherein
- one state comprises the increased formation of nucleus particles from the thermal decomposition of the silicon containing gas, and
- another state comprises the mainly occurring separation of the silicon with expansion of the diameter of such particles;
with a reaction method comprising at least two operating states, wherein
- in one operating state the partial pressure of the silicon containing gas is > 200 mbar, and
- in another operating state the partial pressure of the silicon containing gas is < 200 mbar;
b) manufacturing electronic components from the granular silicon produced.

## Revendications

1. Fabrication de silicium granulaire par décomposition thermique d'un gaz contenant du silicium, **caractérisée en ce qu'**une conduite du procédé est réalisée avec au moins deux états opératoires, dans lesquels
a) dans un état, des particules germes sont générées en nombre croissant à partir de la décomposition thermique du gaz contenant du silicium, et
b) dans un état ultérieur, ces particules grossissent par la séparation du silicium qui se produit principalement,
dans laquelle une conduite du procédé est réalisée avec au moins deux états opératoires, dans lesquels
c) dans un état opératoire, la pression partielle du gaz contenant du silicium est supérieure à 200 mbar et
d) dans un état opératoire ultérieur la pression partielle du gaz contenant du silicium est inférieure à 200 mbar.

2. Procédé selon la revendication 1, **caractérisée en ce que** les états opératoires a) et b) d'une part ou c) et d) d'autre part sont interrompus par un ou plusieurs autres états opératoires.

3. Procédé selon la revendication 2, **caractérisé en ce que** les autres états opératoires concernent un rinçage avec des gaz inertes ou des gaz réactifs, une augmentation ou un abaissement de la température, une modification de la concentration du gaz contenant du silicium, une modification de la vitesse du gaz, un ajout supplémentaire de gaz contenant du silicium ou l'addition ou le prélèvement de particules.

4. Procédé selon au moins une des revendications 1 à 3, **caractérisé en ce que** la décomposition thermique du gaz contenant du silicium est effectuée en présence de particules au travers desquelles le gaz introduit afflue, à tel point que les particules sont fluidisées et forment un lit fluidisé.

5. Procédé selon la revendication 4, **caractérisé en ce que** les particules utilisées sont des particules de silicium.

6. Procédé selon au moins une des revendications 4 à 5, **caractérisé en ce que** les particules ont un diamètre entre 50 et 5000 µm.

7. Procédé selon au moins une des revendications 4 à 6, **caractérisé en ce que** la vitesse d'écoulement du gaz introduit prend les valeurs de 1 à 10 en proportion de la vitesse de perte.

8. Procédé selon au moins une des revendications 1 à 7, **caractérisé en ce que** l'ajout supplémentaire de particules et la libération du silicium produit sont effectués de manière continue ou par palier.

9. Procédé selon au moins une des revendications 1 à 8, **caractérisé en ce que** le gaz utilisé, contenant du silicium, est un silane.

10. Procédé selon au moins une des revendications 1 à 9, **caractérisé en ce que** le gaz utilisé, contenant du silicium, est SiH₄ et que la réaction est effectuée sous des températures allant de 500 à 1400 °C.

11. Procédé pour la fabrication de composants photovoltaïques, comprenant les étapes suivantes :
a) fabrication de silicium granulaire par décomposition thermique d'un gaz contenant du silicium, dans laquelle une conduite du procédé comprend au moins deux états opératoires, dans lesquels
- dans un état, des particules germes sont générées en nombre croissant à partir de la décomposition thermique du gaz contenant du silicium, et
- dans un état ultérieur, ces particules grossissent par la séparation du silicium qui se produit principalement,
dans laquelle une conduite du procédé est réalisée avec au moins deux états opératoires, dans lesquels
- dans un état opératoire, la pression partielle du gaz contenant du silicium est supérieure à 200 mbar et
- dans un état opératoire ultérieur la pression partielle du gaz contenant du silicium est inférieure à 200 mbar,
b) fabrication des composants photovoltaïques, à partir du silicium granulaire produit.

12. Procédé pour la fabrication de composants électroniques, comprenant les étapes suivantes :
a) fabrication de silicium granulaire par décomposition thermique d'un gaz contenant du silicium, dans laquelle une conduite du procédé comprend au moins deux états opératoires, dans lesquels
- dans un état, des particules germes sont générées en nombre croissant à partir de la décomposition thermique du gaz contenant du silicium, et
- dans un état ultérieur, ces particules grossissent par la séparation du silicium qui se produit principalement,
dans laquelle une conduite du procédé est réalisée avec au moins deux états opératoires, dans lesquels
- dans un état opératoire, la pression partielle du gaz contenant du silicium est supérieure à 200 mbar et
- dans un état opératoire ultérieur la pression partielle du gaz contenant du silicium est inférieure à 200 mbar,
b) fabrication des composants électroniques, à partir du silicium granulaire produit.
